# EUROPEAN PATENT APPLICATION

(11) **EP 4 112 184 A1**
(43) Date of publication of application: **04.01.2023**
(21) Application number: 21759654.3
(22) Date of filing: 18.02.2021
(51) Int. Cl.: B05B 17/06, H01L 21/365, H01L 21/368, C23C 16/455

(54) **ATOMIZING APPARATUS FOR FILM FORMATION AND FILM FORMING APPARATUS USING SAME, AND SEMICONDUCTOR FILM**

(30) Priority: 27.02.2020 JP 2020032301
(71) Applicant: Shin-Etsu Chemical Co., Ltd., Tokyo 100-0005 (JP); Kochi Prefectural Public University Corporation, Kochi-shi, Kochi 780-8515 (JP)
(72) Inventor: HASHIGAMI, Hiroshi, Annaka-shi, Gunma 379-0195 (JP); KAWAHARAMURA, Toshiyuki, Kami-shi, Kochi 782-8502 (JP)
(74) Representative: Sonnenhauser, Thomas Martin
(86) International application number: PCT/JP2021/006045
(87) International publication number: WO 2021/172152

(57) **Abstract**

The present invention is an atomizing apparatus for film formation, including: a raw-material container configured to accommodate a raw-material solution; a cylindrical member configured to spatially connect inside of the raw-material container to an outer unit, and disposed such that a lower end of the cylindrical member does not touch a liquid surface of the raw-material solution in the raw-material container; an ultrasound generator having at least one ultrasound generation source configured to emit ultrasound; and a liquid tank where the ultrasound propagates to the raw-material solution through a middle solution. Provided that a center line of an ultrasound-emitting surface of the ultrasound generation source is designated as u, the ultrasound generation source is provided such that an intersection P between the center line u and a plane containing a side wall surface of the cylindrical member and an extension of the side wall surface of the cylindrical member is located below a lower end point B of the cylindrical member. This provides an atomizing apparatus for film formation, enabling high-quality thin film formation with suppressed particle adhesion.

## Description

### TECHNICAL FIELD

The present invention relates to an atomizing apparatus for film formation, a film forming apparatus using the atomizing apparatus, and a semiconductor film.

### BACKGROUND ART

Mist Chemical Vapor Deposition (Mist CVD. Hereinafter, also referred to as "mist CVD method") has been developed in which a thin film is formed on a substrate by using a raw material atomized into a mist form. This method has been utilized to prepare oxide semiconductor film etc. (Patent Document 1, 2). In film formation according to the mist CVD method, mist is obtained with ultrasound as a general technique.

### CITATION LIST

### PATENT LITERATURE

Patent Document 1: JP 2013-028480 A
Patent Document 2: JP 2014-063973 A

### SUMMARY OF INVENTION

### TECHNICAL PROBLEM

However, a method for atomizing a raw material to form high-quality film has not been established yet, and there is a problem that numerous particles reflecting the raw-material mist quality adhere to the prepared film. Moreover, it is known that when the film-formation speed is increased, for example, if mist is supplied in larger amount, such particles adhere more noticeably. It has been desired to achieve both high film quality and productivity.

The present invention has been made to solve the above problems. An object of the present invention is to provide: an atomizing apparatus for film formation which enables efficient formation of a high-quality thin film with particle adhesion suppressed; and a film forming apparatus for forming a high-quality film in high productivity by using this atomizing apparatus. Another object of the present invention is to provide a high-quality semiconductor film with significantly lowered particle concentration on the film surface.

### SOLUTION TO PROBLEM

The present invention has been made to achieve the object, and provides an atomizing apparatus for film formation, comprising:
a raw-material container configured to accommodate a raw-material solution;
a cylindrical member configured to spatially connect inside of the raw-material container to an outer unit, and disposed such that a lower end of the cylindrical member does not touch a liquid surface of the raw-material solution in the raw-material container;
an ultrasound generator having at least one ultrasound generation source configured to emit ultrasound; and
a liquid tank where the ultrasound propagates to the raw-material solution through a middle solution, wherein
provided that a center line of an ultrasound-emitting surface of the ultrasound generation source is designated as u,
the ultrasound generation source is provided such that an intersection P between the center line u and a plane containing a side wall surface of the cylindrical member and an extension of the side wall surface of the cylindrical member is located below a lower end point B of the cylindrical member.

Such an atomizing apparatus for film formation makes it possible to stably obtain favorable, high-quality and high-density mist, which is suitable for film formation. Thus, the atomizing apparatus for film formation enables efficient formation of high-quality film with fewer particles.

In this case, the ultrasound generation source is preferably provided such that the center line u reaches a side wall of the raw-material container.

In this manner, mist with higher density can be obtained more stably.

In this case, the ultrasound generation source is preferably provided such that a distance between the intersection P and the lower end point B is 10 mm or more.

In this manner, mist with higher quality can be obtained more stably.

In this case, the ultrasound generation source is preferably provided such that the distance between the intersection P and the lower end point B is 25 mm or more.

In this manner, mist with further higher quality can be obtained furthermore stably.

In addition, the present invention provides a film forming apparatus comprising at least:
an atomizer configured to atomize a raw-material solution to form a raw-material mist; and
a film-forming unit configured to supply the mist to a substrate to form a film on the substrate, wherein the film forming apparatus comprises the above-described atomizing apparatus for film formation as the atomizer.

Such an apparatus is capable of forming high-quality film with high productivity.

The present invention further provides a semiconductor film comprising a corundum crystal structure containing Ga, wherein
the semiconductor film has a surface whose concentration of particles with a diameter of 0.3 µm or more is 50/cm² or less.

Such a semiconductor film is a high-quality semiconductor film suitable for semiconductor device manufacturing.

In this case, the semiconductor film comprising a corundum crystal structure containing Ga preferably comprises α-Ga₂O₃.

This is a high-quality semiconductor film and more suitable for semiconductor device manufacturing.

In this case, the semiconductor film preferably has a surface area of 50 cm² or more.

This is a semiconductor film with higher quality and high productivity.

In this case, the semiconductor film preferably has a film thickness of 1 µm or more.

This semiconductor film has better quality, is more suitable for semiconductor device, and further can improve the design freedom for semiconductor device.

### ADVANTAGEOUS EFFECTS OF INVENTION

As described above, the present invention makes it possible to provide an atomizing apparatus with which high-quality and high-density mist is stably obtained for film formation. Moreover, the present invention makes it possible to provide a film forming apparatus capable of forming high-quality film in high productivity. Further, the present invention makes it possible to provide a semiconductor film with significantly lowered particle concentration.

### BRIEF DESCRIPTION OF DRAWINGS

FIG. 1 is a diagram showing a configuration of an atomizing apparatus for film formation according to the present invention.
FIG. 2 is a diagram for explaining a mist generation section of the inventive atomizing apparatus for film formation.
FIG. 3 is a diagram for explaining one embodiment of a configuration of a film forming apparatus according to the present invention.
FIG. 4 is a diagram for explaining another embodiment of the configuration of the inventive film forming apparatus.

### DESCRIPTION OF EMBODIMENTS

Hereinafter, the present invention will be described in detail, but the present invention is not limited thereto.

As noted above, there have been demands for: an atomizing apparatus for film formation which enables formation of high-quality thin film with particle adhesion suppressed; and a film forming apparatus for forming high-quality film in high productivity by using this atomizing apparatus. Further, high-quality semiconductor films with less particles have been demanded.

The present inventors have earnestly studied the above problems and consequently found that high-quality thin films with suppressed particle adhesion can be formed in high productivity by using an atomizing apparatus for film formation, including: a raw-material container configured to accommodate a raw-material solution; a cylindrical member configured to spatially connect inside of the raw-material container to an outer unit, and disposed such that a lower end of the cylindrical member does not touch a liquid surface of the raw-material solution in the raw-material container; an ultrasound generator having at least one ultrasound generation source configured to emit ultrasound; and a liquid tank where the ultrasound propagates to the raw-material solution through a middle solution. In the atomizing apparatus for film formation, provided that a center line of an ultrasound-emitting surface of the ultrasound generation source is designated as u, the ultrasound generation source is provided such that an intersection P between the center line u and a plane containing a side wall surface of the cylindrical member and an extension of the side wall surface of the cylindrical member is located below a lower end point B of the cylindrical member. This finding has led to the completion of the present invention.

Hereinbelow, description will be given with reference to the drawings.

### (Atomizing Apparatus for Film Formation)

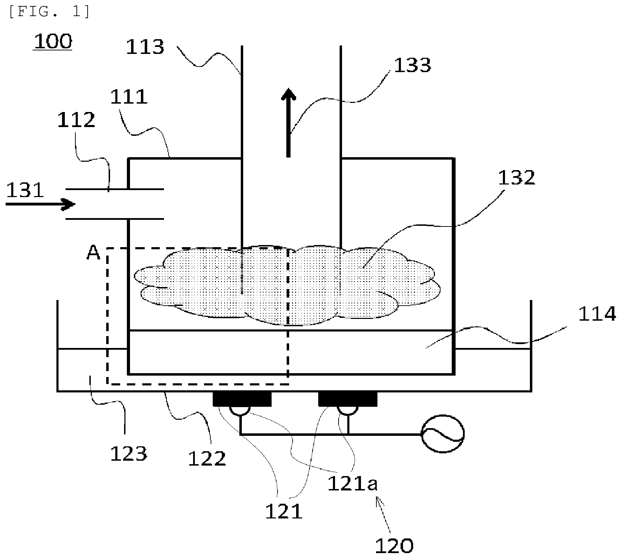

FIG. 1 shows an atomizing apparatus 100 for film formation according to the present invention. The atomizing apparatus 100 for film formation includes: a raw-material container 111 configured to accommodate a raw-material solution 114; a cylindrical member 113 configured to spatially connect the inside of the raw-material container 111 to an outer unit, and disposed such that a lower end of the cylindrical member 113 does not touch a liquid surface of the raw-material solution 114 in the raw-material container 111; an ultrasound generator 120 having at least one ultrasound generation source (ultrasonic vibration plate) 121 configured to emit ultrasound; and a liquid tank 122, where ultrasound propagates to the raw-material solution 114 through a middle solution 123.

In the raw-material container 111, a carrier gas inlet 112 for entry of a carrier gas 131 is disposed. The shapes of the raw-material container 111 and the cylindrical member 113 are not particularly limited, but these members having columnar shape enable smooth flow of a gas mixture 133 of the carrier gas 131 and a mist 132. The carrier gas inlet 112 is preferably provided higher than the lower end of the cylindrical member 113 inside the raw-material container 111. In this manner, the carrier gas 131 and the mist 132 can be sufficiently mixed. Additionally, although unillustrated, the raw-material container 111 may include a mechanism for replenishing the raw-material solution 114 depending on the consumption.

The members constituting atomizing apparatus for film formation are not particularly limited, as long as the materials and structures are chemically stable with respect to the raw-material solution 114 and have sufficient mechanical strength. It is possible to utilize, for example, metal, plastic material, glass, metal materials whose surfaces are coated with plastic material, etc.

The ultrasound generator 120 includes at least the ultrasound generation source(s) 121. Moreover, an oscillator or the like provided to the ultrasound generator 120 can drive the ultrasound generation source 121. Meanwhile, the liquid tank 122 accommodates the middle solution 123 through which ultrasound emitted from the ultrasound generation source 121 is propagated to the raw-material solution 114. The middle solution 123 accommodated in the liquid tank 122 is not particularly limited, as long as ultrasound is not inhibited. For example, water, an alcohol, an oil, and so forth may be used. The liquid tank 122 and the like are not particularly limited, as long as the materials and structures are chemically stable with respect to the middle solution 123 and have certain mechanical strength. It is possible to utilize, for example, metal, plastic material, glass, metal materials whose surfaces are coated with plastic material, etc. Additionally, although unillustrated, the liquid tank 122 may further include means for detecting and controlling the liquid amount and temperature of the middle solution 123.

The ultrasound generation source 121 has an ultrasound-emission surface with a flat shape, and the emission direction may be fixed after inclining this emission surface, or may be adjustable by inclining the emission surface with an angle adjusting mechanism 121a. In addition, the ultrasound generation source 121 includes at least one ultrasonic vibration plate (not shown) which may be a vibration plate alone or may be constituted in combination with means for controlling ultrasound emission direction. Moreover, the number of the ultrasound generation sources 121 to be provided may be one or more, depending on desired mist density, the size of the raw-material container 111, etc. The frequency of ultrasound emitted from the ultrasound generation source 121 is not limited, as long as the mist 132 to be generated has desired particle diameter and particle size. The frequency to be utilized may be, for example, 1.5 MHz to 4.0 MHz. Thereby, the raw-material solution 114 is formed into mist of droplets with a micron size, which is suitable for film formation.

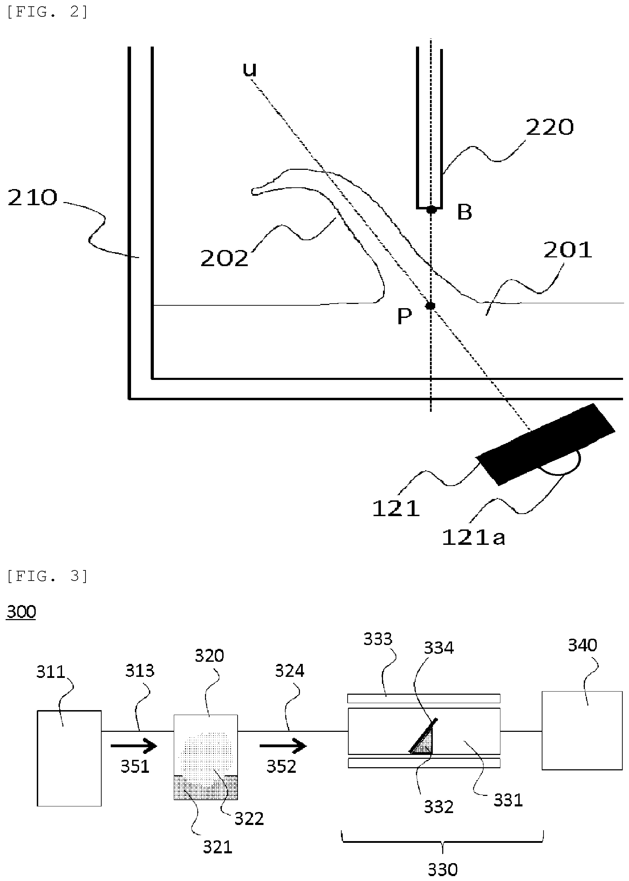

FIG. 2 is a diagram for explaining a mist generation section of the inventive atomizing apparatus for film formation. Fig. 2 is an enlarged diagram corresponding to a section A of a dashed line frame in FIG. 1, and schematically showing a state near the liquid surface of the raw-material solution when ultrasound is emitted (but the liquid tank is omitted). A center line of an ultrasound-emitting surface of an ultrasound generation source 121 is designated as "u". When ultrasound is emitted from the ultrasound generation source 121 below a raw-material solution 201 in a direction of the center line u, a liquid column 202 is formed on the raw-material solution 201 along the ultrasound emission direction, and a mist is formed simultaneously. In this event, the ultrasound generation source 121 is inclined with an angle adjusting mechanism 121a such that the center line u does not intersect a cylindrical member 220. In other words, the ultrasound generation source 121 is oriented in a direction to a side wall of a raw-material container 210 within such a range that an intersection P between the center line u and a plane containing a side wall surface of the cylindrical member 220 and an extension of the side wall of the cylindrical member 220 is located below a lower end point B of the cylindrical member 220.

Moreover, the ultrasound generation source 121 is preferably provided such that the center line u reaches the side wall of the raw-material container 210. In this manner, it is possible to more stably obtain mist with higher density.

Further, the ultrasound generation source 121 may be provided such that a distance PB between the intersection P and the lower end point B is 10 mm or more; more preferably, the ultrasound generation source 121 may be provided such that the distance PB is 25 mm or more. With PB of 10 mm or more, the gas mixture flows more smoothly, making it possible to effectively prevent decreases in the mist supply amount and in the film-formation speed. It is also possible to effectively prevent defect formation in the film on a substrate, which would otherwise occur when the gas mixture contains a larger amount of droplets of relatively large particle diameter possibly causing unreacted materials and particles on the substrate. Consequently, the film quality is further improved. Note that the upper limit value of PB is not particularly limited, and can be appropriately set depending on the size of the raw-material container 210, etc. For example, the PB can be 100 mm or less.

### (Film Forming Apparatus)

The present invention further provides a film forming apparatus which employs the atomizing apparatus for film formation described in FIGs. 1 and 2.

FIG. 3 is a diagram for explaining one embodiment of a configuration of the inventive film forming apparatus. The inventive film forming apparatus 300 includes at least: an atomizer 320 configured to atomize a raw-material solution 321 to form a raw-material mist 322; and a film-forming unit 330 configured to supply the mist 322 to a substrate 334 to form a film on the substrate 334. The film forming apparatus 300 includes, as the atomizer, the inventive atomizing apparatus 100 for film formation described with reference to FIG. 1 and FIG. 2. Further, a carrier-gas supplier 311, the atomizer 320, and the film-forming unit 330 are connected with pipes 313, 324.

The carrier-gas supplier 311 may be, for example, an air compressor, various gas cylinders or nitrogen gas separators, etc., and may include a mechanism for controlling the supply flow amount of gas.

The pipes 313, 324 are not particularly limited, as long as the pipes have sufficient stability with respect to temperature and so forth near the raw-material solution 321 and the film-forming unit 330. It is possible to widely use pipes made of quartz or common resins, such as polyethylene, polypropylene, vinyl chloride, silicon resin, urethane resin, and fluorine resin.

Moreover, although unillustrated, another pipe from the carrier-gas supplier 311 bypassing the atomizer 320 may be connected to the pipe 324 so as to allow dilution-gas supply to a gas mixture 352.

Multiple atomizers 320 may be provided depending on the materials for film formation, etc. Moreover, in this case, gas mixtures 352 supplied from the multiple atomizers 320 to the film-forming unit 330 may be independently supplied to the film-forming unit 330, or may be mixed in the pipe 324 or another container for mixing (not shown) that is provided additionally.

The film-forming unit 330 may include a film forming chamber 331, a susceptor 332 disposed in the film forming chamber 331 and configured to hold the substrate 334 where a film is formed, and a heater 333 configured to heat the substrate 334.

The structure and so forth of the film forming chamber 331 are not particularly limited. For example, a metal such as aluminum and stainless steel may be employed, or quartz or silicon carbide may be employed when a film is formed at higher temperature.

The heater 333 can be selected depending on the materials and structures of the substrate 334, the susceptor 332 and the film forming chamber 331. For example, a resistance heating heater or a lamp heater is suitably used.

A carrier gas 351 is mixed with the mist 322 formed in the atomizer 320. The resulting gas mixture 352 is conveyed to the film-forming unit 330 to form a film.

Further, the inventive film forming apparatus may further include a discharge unit 340. The discharge unit 340 may be connected to the film-forming unit 330 with a pipe or the like, or may be disposed with a space in between. Moreover, the structure and configuration of the discharge unit 340 are not particularly limited, as long as the discharge unit 340 is made of a material that is stable with respect to heat, gas, and product discharged from the film-forming unit 330. It is possible to use known common exhaust fan or exhaust pump. Further, depending on the nature of the gas and product to be discharged, for example, a mist trap, a wet scrubber, a bag filter, a purifier, or the like may be installed.

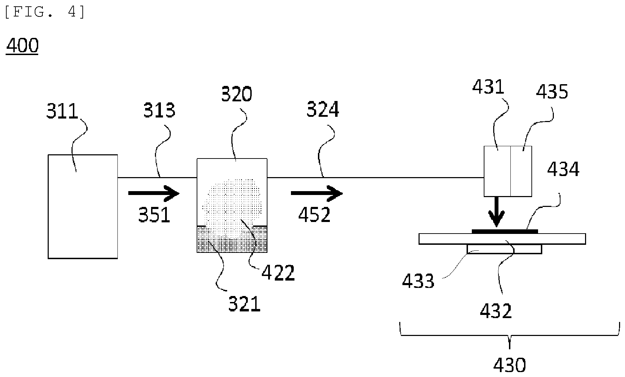

FIG. 3 explains the embodiment of the film-forming unit 330 in which the substrate 334 is disposed inside the film forming chamber 331. Nevertheless, the inventive film forming apparatus is not limited thereto, and may be a film forming apparatus 400 as shown in FIG. 4. A nozzle 431 configured to eject a gas mixture 452 containing a mist 422 may be used as a film-forming unit 430 to directly blow the gas mixture 452 onto a substrate 434 disposed on a susceptor 432 for film formation.

In this case, a driver configured to drive one or both of the nozzle 431 and the susceptor 432 in a horizontal direction may be provided, so that a film is formed by changing relative positions of the substrate 434 and the nozzle 431 in the horizontal direction. Moreover, the susceptor 432 may include a heater 433 configured to heat the substrate 434. Further, the film-forming unit 430 may include a discharge unit 435. The discharge unit 435 may be integrated with the nozzle 431, or may be separately disposed. Note that the descriptions of the same members as in FIGs. 1 to 3 are omitted as appropriate.

### (Semiconductor Film)

A semiconductor film according to the present invention is a semiconductor film having a corundum crystal structure containing Ga, and the semiconductor film has a surface whose concentration of particles with a diameter of 0.3 µm or more is 50/cm² or less. Particles with a diameter of 0.3 µm or more considerably influence the properties of semiconductor device prepared based on a semiconductor film. The semiconductor film having such concentration of particles with diameters of 0.3 µm or more as described above is of high quality and suitable for semiconductor device manufacturing.

Note that, in the present invention, the term "particle" refers to ones observed as particles when semiconductor film surface is observed, and includes ones incorporated in the film and integrated with the film and ones attached as foreign matter on the semiconductor film surface. Additionally, the particle diameter is a value based on the particle size measured with a particle measurement instrument according to light scattering. The particle size is determined through calibration of the measurement instrument with reference particles of multiple sizes. Specifically, the particle size is a classified value, and a measurement value of particles measured with a measurement instrument is compared with measurement values of reference particles having been measured. Particles on the semiconductor film surface can be measured, for example, with a laser scattering-based particle counter.

The inventive semiconductor film is not limited, as long as the semiconductor film has a corundum crystal structure containing Ga. The inventive semiconductor film is particularly preferably α-Ga₂O₃. α-Ga₂O₃ forms a high-quality semiconductor film that is more suitable for semiconductor device manufacturing. More preferably, the semiconductor film has a surface area of 50 cm² or more. Such a semiconductor film is a semiconductor film having higher quality and highly productive.

Further preferably, the semiconductor film has a film thickness of 1 µm or more. Such a semiconductor film has better quality and is more suitable for semiconductor device, further enabling more free designing of semiconductor devices.

The inventive semiconductor film can be obtained by using a film forming apparatus including the inventive atomizing apparatus for film formation such that the film is formed on a substrate disposed in a film forming chamber of the film forming apparatus. The substrate is not particularly limited, as long as film formation is possible and the film can be supported. The material of the substrate is not particularly limited, either. A known substrate may be used, and the material may be an organic or inorganic compound. Examples thereof include, but are not limited to, polysulfone, polyether sulfone, polyphenylene sulfide, polyether ether ketone, polyimide, polyether imide, fluorinated resin; metals, such as iron, aluminum, stainless steel, and gold; silicon, sapphire, quartz, glass, gallium oxide, etc. Regarding the shape, the substrate may be any shape. The present invention is effective for any shape. Examples of the shape include plate-like shapes such as flat plate and disk, fibrous, rod-like, columnar, prismatic, cylindrical, helical, spherical, annular shapes, etc. In the present invention, a plate-like substrate is preferable. The thickness of the plate-like substrate is not particularly limited, but is preferably 10 to 2000 pm, more preferably 50 to 800 µm. The plate-like substrate has an area of preferably 50 mm² or more; more preferably, the diameter is 2 inches (50 mm) or more. After the semiconductor film is formed on a substrate, the semiconductor film may be left alone by removing the substrate.

The raw-material solution is not particularly limited, as long as it contains Ga and a material that can form mist. Such material may be an inorganic material or an organic material. A metal or a metal compound is suitably used. Besides Ga, the raw-material solution to be used may contain one or more kinds of metals selected from iron, indium, aluminum, vanadium, titanium, chromium, rhodium, nickel, and cobalt.

It is possible to suitably use the raw-material solution in which the aforementioned metal(s) are dissolved or dispersed in a form of complex or salt in an organic solvent or water. Examples of the complex form include acetylacetonate complexes, carbonyl complexes, ammine complexes, hydrido complexes, etc. Examples of the salt form include metal chloride salts, metal bromide salts, metal iodide salts, etc. Moreover, solutions obtained by dissolving the metals in hydrobromic acid, hydrochloric acid, hydroiodic acid, or the like can be used as aqueous solutions of the salts.

Further, the raw-material solution may be mixed with an additive, such as a hydrohalic acid or an oxidant. Examples of the hydrohalic acid include hydrobromic acid, hydrochloric acid, hydroiodic acid, etc. Among these, hydrobromic acid or hydroiodic acid is preferable. Examples of the oxidant include peroxides, such as hydrogen peroxide (H₂O₂), sodium peroxide (Na₂O₂), barium peroxide (BaO₂), and benzoyl peroxide (C₆H₅CO)₂O₂; organic peroxides, such as hypochlorous acid (HClO), perchloric acid, nitric acid, ozone water, peracetic acid, and nitrobenzene; etc.

Further, the raw-material solution may contain a dopant. The dopant is not particularly limited. Examples thereof include n-type dopants, such as tin, germanium, silicon, titanium, zirconium, vanadium, and niobium; p-type dopants, such as copper, silver, tin, iridium, and rhodium; etc. The dopant concentration may be, for example, approximately 1×10¹⁶/cm³ to 1×10²²/cm³, may be a low concentration of approximately 1×10¹⁷/cm³ or less, or may be a high concentration of approximately 1×10²⁰/cm³ or more.

### EXAMPLE

Hereinafter, the present invention will be described in detail by showing Examples, but the present invention is not limited thereto.

### (Example 1)

The atomizing apparatus for film formation shown in FIGs. 1 and 2 and the film forming apparatus shown in FIG. 3 were used to form an α-gallium oxide film.

In the atomizing apparatus for film formation, the raw-material container and cylindrical member used were both made of borosilicate glass, and a film forming chamber made of quartz was prepared. A gas cylinder filled with nitrogen gas was used to supply carrier gas. The gas cylinder and the atomizing apparatus for film formation were connected with a urethane resin tube, and the atomizing apparatus for film formation was further connected to the film forming chamber with a quartz pipe.

An aqueous solution containing 0.02 mol/L of gallium acetylacetonate was mixed with hydrochloric acid with a concentration of 34% such that the volume ratio of the latter was 1%. The mixture was stirred with a stirrer for 60 minutes to prepare a raw-material solution, and the raw-material container was filled therewith. The atomizing apparatus for film formation used had two ultrasonic vibration plates (frequency: 2.4 MHz). The ultrasound emission direction and the position of the cylindrical member were adjusted such that the distance BP between the point B of the lower end of the cylindrical member and the point P where the plane of the side wall of the cylindrical member intersected the ultrasound emission direction was 30 mm.

Next, a c-plane sapphire substrate with a thickness of 0.6 mm and a diameter of 4 inches (approximately 10 cm) was placed on a quartz susceptor disposed in the film forming chamber, and heated such that the substrate temperature reached 500°C.

Next, with the ultrasonic vibration plates, ultrasonic vibration was propagated through water to the precursor in the raw-material container to atomize the raw-material solution (mist was formed).

Next, a nitrogen gas was added to the raw-material container at a flow rate of 5 L/min. A gas mixture of the mist and the nitrogen gas was supplied to the film forming chamber for 60 minutes to form a film. Immediately thereafter, supplying the nitrogen gas was stopped, and supplying the gas mixture to the film forming chamber was stopped.

In the X-ray diffraction measurement, the peak appeared at 2θ=40.3°. This verified that the prepared crystal layer of the laminate was α-phase Ga₂O₃.

Then, the film thickness of the prepared film was measured by the light reflectance analysis, and the growth rate was calculated. Moreover, the concentration of particles (diameter: 0.5 µm or more) on the film was evaluated with a substrate inspector (KLA candela-CS10).

### (Example 2)

A film was formed as in Example 1, except that the nitrogen gas flow rate was 10 L/min.

In the X-ray diffraction measurement, the peak appeared at 2θ=40.3°. This verified that the prepared crystal layer of the laminate was α-phase Ga₂O₃.

Then, the film was evaluated as in Example 1.

### (Example 3)

An α-gallium oxide film was formed using the same apparatus and raw-material solution as those in Example 1, except the film forming apparatus used was the film forming apparatus shown in FIG. 4. A mist-ejecting nozzle made of quartz was used. An aluminum hot plate was used as the susceptor, and the substrate was heated to 450°C. Next, the susceptor was reciprocally driven in the horizontal direction at a speed of 10 mm/s below the mist-ejecting nozzle. Further, the gas mixture was supplied from the mist-ejecting nozzle to the substrate on the susceptor at 5 L/min for 60 minutes to form a film.

In the X-ray diffraction measurement, the peak appeared at 2θ=40.3°. This verified that the prepared crystal layer of the laminate was α-phase Ga₂O₃. Then, the film was evaluated as in Example 1.

### (Comparative Example 1)

A film was formed as in Example 1, except that ultrasound was emitted vertically above from the ultrasound generator toward the inside of the cylindrical member.

In the X-ray diffraction measurement, the peak appeared at 2θ=40.3°. This verified that the prepared crystal layer of the laminate was α-phase Ga₂O₃. Then, the film was evaluated as in Example 1.

### (Comparative Example 2)

A film was formed as in Example 2, except that ultrasound was emitted vertically above from the ultrasound generator toward the inside of the cylindrical member.

In the X-ray diffraction measurement, the peak appeared at 2θ=40.3°. This verified that the prepared crystal layer of the laminate was α-phase Ga₂O₃. Then, the film was evaluated as in Example 1.

Table 1 shows the growth rates and the particle concentrations of the films obtained in Examples 1, 2, 3 and Comparative Examples 1, 2.

**[Table 1]**

| | Growth rate [nm/min] | Particle concentration [the number of particles/cm²] |
|---|---|---|
| Example 1 | 13.5 | 0.11 |
| Example 2 | 30.1 | 0.20 |
| Example 3 | 14.0 | 0.15 |
| Comparative Example 1 | 4.3 | 12.07 |
| Comparative Example 2 | 11.3 | 56.50 |

As can be seen from Table 1 and shown by Examples 1, 2, 3, the inventive film forming apparatuses were excellent and capable of forming high-quality films at high growth rate with fewer particles. In contrast, in Comparative Examples 1, 2 using the atomizing apparatus for film formation of the conventional technique, the growth rates were low, and a large number of particles adhered.

### (Example 4)

A film was formed under the same conditions as in Example 1, except that the film-formation time, that is, the time during which the gas mixture of the mist and nitrogen gas was supplied to the film forming chamber, was 120 minutes. A semiconductor film having a film thickness of 1 µm or more was formed. Then, the concentration of particles (diameter: 0.3 µm or more) on the film surface obtained by the film formation was evaluated with a substrate inspector (KLA candela-CS10).

### (Example 5)

A film was formed under the same conditions as in Example 2, except that the film-formation time was 120 minutes. The film was evaluated under the same conditions as in Example 4.

### (Example 6)

A film was formed under the same conditions as in Example 3, except that the film-formation time was 120 minutes. The film was evaluated under the same conditions as in Example 4.

### (Comparative Example 3)

A film was formed under the same conditions as in Comparative Example 1, except that the film-formation time was 120 minutes. The film was evaluated under the same conditions as in Example 4.

### (Comparative Example 4)

A film was formed under the same conditions as in Comparative Example 2, except that the film-formation time was 120 minutes. The film was evaluated under the same conditions as in Example 4.

Table 2 shows the growth rates and the particle concentrations of the films obtained in Examples 4, 5, 6 and Comparative Examples 3, 4.

**[Table 2]**

| | Growth rate [nm/min] | Particle concentration [the number of particles/cm²] |
|---|---|---|
| Example 4 | 14.2 | 0.10 |
| Example 5 | 29.8 | 0.48 |
| Example 6 | 14.1 | 0.24 |
| Comparative Example 3 | 4.2 | 66.01 |
| Comparative Example 4 | 11.0 | 106.50 |

As can be seen from Table 2 and shown by Examples 4, 5, 6, when the inventive film forming apparatuses were used for the film formation, high-quality films were successfully formed at high growth rate with fewer particles. Particularly, the semiconductor films were obtained such that the particle concentration with the diameter of 0.3 µm or more was 50/cm² or less. In contrast, in Comparative Examples 3, 4 using the atomizing apparatus for film formation of the conventional technique, the growth rates were low, and a large number of particles adhered.

It should be noted that the present invention is not limited to the above-described embodiments. The embodiments are just examples, and any embodiments that substantially have the same feature and demonstrate the same functions and effects as those in the technical concept disclosed in claims of the present invention are included in the technical scope of the present invention.

## Claims

1. An atomizing apparatus for film formation, comprising:
a raw-material container configured to accommodate a raw-material solution;
a cylindrical member configured to spatially connect inside of the raw-material container to an outer unit, and disposed such that a lower end of the cylindrical member does not touch a liquid surface of the raw-material solution in the raw-material container;
an ultrasound generator having at least one ultrasound generation source configured to emit ultrasound; and
a liquid tank where the ultrasound propagates to the raw-material solution through a middle solution, wherein
provided that a center line of an ultrasound-emitting surface of the ultrasound generation source is designated as u,
the ultrasound generation source is provided such that an intersection P between the center line u and a plane containing a side wall surface of the cylindrical member and an extension of the side wall surface of the cylindrical member is located below a lower end point B of the cylindrical member.

2. The atomizing apparatus for film formation according to claim 1, wherein the ultrasound generation source is provided such that the center line u reaches a side wall of the raw-material container.

3. The atomizing apparatus for film formation according to claim 1 or 2, wherein the ultrasound generation source is provided such that a distance between the intersection P and the lower end point B is 10 mm or more.

4. The atomizing apparatus for film formation according to any one of claims 1 to 3, wherein the ultrasound generation source is provided such that a distance between the intersection P and the lower end point B is 25 mm or more.

5. A film forming apparatus comprising at least:
an atomizer configured to atomize a raw-material solution to form a raw-material mist; and
a film-forming unit configured to supply the mist to a substrate to form a film on the substrate, wherein
the film forming apparatus comprises the atomizing apparatus for film formation according to any one of claims 1 to 4 as the atomizer.

6. A semiconductor film comprising a corundum crystal structure containing Ga, wherein
the semiconductor film has a surface whose concentration of particles with a diameter of 0.3 µm or more is 50/cm² or less.

7. The semiconductor film according to claim 6, wherein the semiconductor film comprising a corundum crystal structure containing Ga comprises α-Ga₂O₃.

8. The semiconductor film according to claim 6 or 7, wherein the semiconductor film has a surface area of 50 cm² or more.

9. The semiconductor film according to any one of claims 6 to 8, wherein the semiconductor film has a film thickness of 1 µm or more.
